# EUROPÄISCHE PATENTSCHRIFT

(11) **EP 1 512 242 B1**
(45) Veröffentlichungstag und Bekanntmachung des Hinweises auf die Patenterteilung: **19.04.2006**
(21) Anmeldenummer: 03759831.5
(22) Anmeldetag: 03.06.2003
(51) Int. Cl.: H04L 1/00, H03M 13/00

(54) **GLEICHE PUNKTIERUNG VON UE IDENTIFIKATIONSDATEN UND NUTZERDATEN BEIM HS-SCCH KANAL**
IDENTICAL PUNCTURING OF UE IDENTIFICATION DATA AND LOAD DATA IN THE HS-SCCH CHANNEL
POINTILLAGE IDENTIQUE POUR DONNEES D'IDENTIFICATION D'EQUIPEMENT UTILISATEUR ET POUR DONNEES UTILES DE CANAL HS-SCCH

(30) Priorität: 13.06.2002 DE 10226394
(43) Veröffentlichungstag der Anmeldung: 09.03.2005
(60) Teilanmeldung: 06003610.0
(73) Patentinhaber: SIEMENS AKTIENGESELLSCHAFT, 80333 München (DE)
(72) Erfinder: DÖTTLING, Martin, 85579 Neubiberg (DE); MICHEL, Jürgen, 81737 München (DE); RAAF, Bernhard, 82061 Neuried (DE); WIEDMANN, Ralf, 81369 München (DE)
(86) Internationale Anmeldenummer: PCT/DE2003/001872
(87) Internationale Veröffentlichungsnummer: WO 2003/107580

(56) Entgegenhaltungen:
- EP-A- 1 091 517
- "Multiplexing and channel coding (TDD), 3GPP TS 25.222 version 5.0.0 (Release 5)" 3GPP TS 25.222 V5.0.0 (RELEASE 5), März 2002 (2002-03), Seite 22-29, 54-56 XP002256032
- SIEMENS: "Change Request R1-02-0605, Rate Matching and Channel Coding for HS-SCCH" 3GPP TSG-RAN1 MEETING #25, R1-02-0605, 12. April 2002 (2002-04-12), Seiten 1-5, XP002256033 in der Anmeldung erwähnt

## Beschreibung

Die vorliegende Erfindung betrifft ein Verfahren zur Datenübertragung, bei dem die Bitrate der Übertragung über den physikalischen Kanal festgelegt ist.

Übertragungskanäle in Mobilfunksystemen bieten beispielsweise aufgrund ihrer Einbettung in gewisse Sendeformate nur feste Daten beziehungsweise Rohdaten-Übertragungsraten an, während die Datenraten verschiedener Signale oder Applikationen davon abweichen. Daher ist es im Allgemeinen notwendig, die Datenraten an einer Schnittstelle aneinander anzupassen.

Eine derartige Anpassung wird nachfolgend an einem Beispiel aus der UMTS-Standardisierung beschrieben:

In UMTS (Universal Mobile Telecommunication System) werden über den "High-Speed Downlink Shared Channel" (HS-DSCH) Datenpakete zu einer Mobilstation (UE= User Equipment) gesendet. Über den "High-Speed Shared Control Channel" (HS-SCCH) wird die zugehörige Kontrollinformation übertragen, wie beispielsweise die für den HS-DSCH verwendeten Channelisation-Codes und das Modulationsschema, beispielsweise QPSK (Quadrature Phase Shift Keying) oder 16QAM (16 Quadrature Amplitude Modulation). Damit die empfangende Mobilstation erkennen kann, dass die Information auf dem HS-SCCH für sie bestimmt ist, wird diese Kontrollinformation beziehungsweise diese Nutzdaten mit einer Identifikationsinformation verknüpft. Man spricht in diesem Zusammenhang auch von einer Maskierung der Daten. Vor der Verknüpfung erfahren sowohl Nutz- als auch Identifikationsdaten eine Codierung sowie jeweils eine anschließende Ratenanpassung.

Dieser Vorgang ist allerdings recht komplex, was insbesondere beim Mobilfunkendgerät insofern nachteilig ist, als diese Codierungs- und Ratenanpassungsvorgänge wieder aufgelöst werden, um auf die ursprünglichen (Nutz)daten zu kommen..

Ausgehend von diesem Stand der Technik ist es Aufgabe der vorliegenden Erfindung, die Ratenanpassung bei einem, von mehreren Kommunikationsteilnehmern gemeinsam genutzten Kanal mit geringer Komplexität durchzuführen.

Diese Aufgabe wird durch ein Verfahren gemäß den Merkmalen des unabhängigen Anspruchs 1 gelöst. Vorteilhafte Weiterbildungen ergeben sich durch die abhängigen Ansprüche.

Kern der Erfindung ist es, bei der Gesamtcodierung in einem von mehreren Kommunikationsteilnehmern genutzten Kanal die Ratenanpassung für Nutzdaten und Identifikationsdaten, mit deren Hilfe kenntlich gemacht wird, für wen die Daten bestimmt sind, nach einem gemeinsamen Schema zu gestalten. Dies hat den Vorteil, dass die Komplexität der Decodierung insbesondere auf der Empfängerseite geringer wird.
Ein weiterer Aspekt der Erfindung zielt auf die Gestaltung eines Ratenanpassungsmusters ab, welches die Ratenanpassung nach einem gemeinsamen Schema bei möglichst gutem Beibehalten der ursprünglichen Information erlaubt.

Vorteile und Ausgestaltungen der Erfindung werden im Folgenden beispielhaft anhand von Figuren erklärt.

Es zeigen
- Figur 1: einen Überblick über die Gesamtcodierung bei einem Kanal, bei dem die zu übertragenden Daten mit Hilfe der Identifikationsdaten maskiert werden;
- Figur 2: ein Schema, das einzelne Vorgänge bei der Gesamtcodierung darstellt;
- Figur 3: die bisherige Realisierung der Gesamtcodierung beim HS-SCCH gemäß dem Stand der Technik;
- Figur 4: eine Ausführungsbeispiel einer erfindungsgemäßen Realisierung der Gesamtcodierung beim HS-SCCH;
- Figur 5: eine beispielhafte Implementierung auf Empfängerseite zum Empfang des HS-SCCH bei der momentan verwendeten Spezifikation (Release 99);
- Figur 6: ein Ausführungsbeispiel der Implementierung auf Empfängerseite bei einer Gesamtcodierung gemäß dem in Figur 4 gezeigten Vorschlag.

### Gesamtcodierung von Nutz- und Identifikationsdaten

### Figur 1

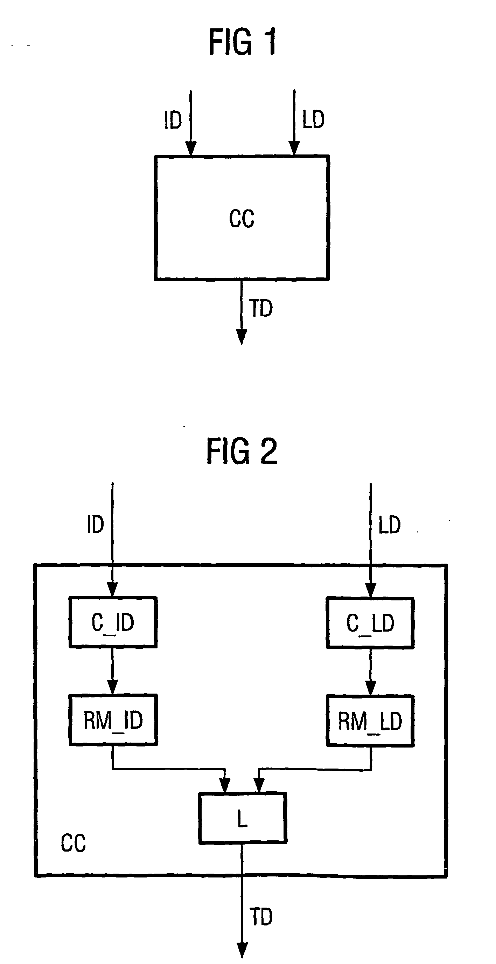

In Figur 1 ist schematisch eine Gesamtcodierung für Nutzdaten (LD: Load Data) und Identifikationsdaten (ID: Identification Data) zu sehen, welche über einen gemeinsam genutzten Kanal in einem Kommunikationssystem gesendet werden. Übertragene Daten (TD: Transferred Data) setzen sich hierbei aus Nutzdaten (LD) zusammen, welche mit den Identifikationsdaten ID verknüpft sind, um kenntlich zu machen, für welchem Empfänger die übertragenen Daten TD bestimmt sind. Die Verknüpfung von Nutzdaten LD und Identifikationsdaten ID geschieht im Rahmen einer Gesamtcodierung (CC: Channel Coding), zumeist einer Kanalcodierung. Unter Kanalcodierung versteht man die Anpassung von Digitalwerten an das physikalische Übertragungsmedium, das heißt beispielsweise eine Codierung mit anschließender Ratenanpassung. Unter Gesamtcodierung wird in diesem Fall die Codierung, Ratenanpassung und Verknüpfung der Nutz- und Identifikationsdaten verstanden. Es ist jedoch nicht zwingend erforderlich, dass alle aufgeführten Schritte stattfinden, die Gesamtcodierung kann beispielsweise auch in einer Codierung alleine ohne Ratenanpassung bestehen.

Das in Figur 1 gezeigte Schema ist an sich bekannt, jedoch unterscheiden sich Stand der Technik und die Erfindung im Vorgehen bei der Gesamtcodierung.

### Figur 2

In Figur 2 sind einzelne Verfahrensblöcke der Gesamtcodierung CC aufgeschlüsselt. Die Nutzdaten LD werden zunächst einer Codierung C_LD unterzogen. Im Rahmen dieser Codierung, wozu insbesondere Faltungscodes ("Convolutional Codes") verwendet werden, wird den Nutzdaten LD Redundanz hinzugefügt, wodurch auf der Empfängerseite eine zuverlässigere Wiedergewinnung der gesendeten Daten TD möglich ist. Der bei der Codierung jeweils verwendete Code wird durch seine Coderate R=K/N charakterisiert, wobei K die Anzahl der zu übertragenden Daten- oder Nachrichten-Bits und N die Anzahl der nach der Codierung vorliegenden Bits bezeichnet. Je kleiner die Coderate ist, desto leistungsfähiger ist in der Regel der Code. Ein mit der Codierung verbundenes Problem ist jedoch, dass die Datenrate um den Faktor R reduziert wird.

Um die Datenrate des codierten Datenstroms an die jeweils mögliche Übertragungsrate anzupassen, wird im Sender eine Ratenanpassung (Ratematching) RM_LD durchgeführt, wobei nach einem bestimmten Muster entweder Bits aus dem Datenstrom entfernt oder in dem Datenstrom wiederholt werden. Das Entfernen von Bits wird als "Punktieren" und das Wiederholen von Bits als "Repetieren" bezeichnet.

In analoger Weise werden die Identifikationsdaten ID zunächst einer Codierung C_ID und anschließend einer Ratenanpassung RM_ID unterzogen. Im Anschluss daran werden Identifikationsdaten und Nutzdaten in einem Verknüpfungsvorgang L miteinander verknüpft, wodurch die zu übertragenden Daten TD gebildet werden.

Das in Figur 2 gezeigte Vorgehen ist dem Prinzip nach bekannt, jedoch unterscheiden sich Stand der Technik und die Erfindung in der Umsetzung der Ratenanpassung für Nutzdaten LD und Identifikationsdaten ID.

### Figur 3

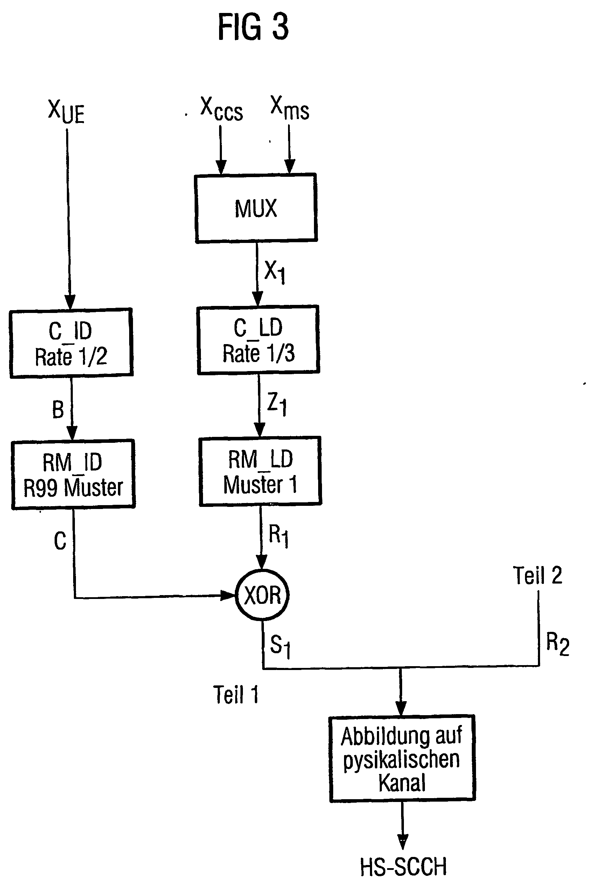

In Figur 3 ist die Implementierung der Gesamtcodierung des HS-SCCH Teil 1 gemäß der derzeitigen Spezifikation UMTS-Standard (FDD, Release 5) abgebildet. Die Nutzdaten LD werden hierbei durch die Kanalinformationsbits x_{ccs,1}, x_{ccs,2}, ... , x_{ccs,7} gebildet. Die Kanalinformationsbits werden in Fachkreisen als "Channelization Code Set Bits" bezeichnet. Des weiteren fließt in die Nutzdaten das Modulation Schema Bit x_{ms,1}, welches auch als "Modulation Scheme Bit" bezeichnet wird, ein. Diese Nutzdaten werden mit einem Rate 1/3 - Faltungsencoder gemäß dem 1999 festgelegten Standard (Release 99) encodiert. Acht vor dieser Codierung am Ende des Bitblocks angehängte, sogenannte Tail Bits ermöglichen eine einfachere und sicherere Decodierung auf Empfängerseite. Der Multiplexer MUX ermöglicht ein abwechselndes Abfragen von Kanalinformationsbits X_{ccs} und dem Modulation Schema Bit Xₘₛ. Die Gesamtheit der nach dem Multiplexer vorliegenden Daten wird als X₁ bezeichnet.
Somit liegen auf der Eingangsseite des Codierers oder Encoders beziehungsweise vor dem Codiervorgang C_LD 16 Bit vor, während auf der Ausgangsseite des Encoders Encod beziehungsweise nach dem Codiervorgang C_LD aufgrund der Rate 1/3 48 Bits vorliegen. Dieser codierte Bitblock sei als Z₁ bezeichnet. Der Index 1 bedeutet, dass es sich um eine Größe, welche den Teil 1 (Part 1) des HS-SCCH betrifft, handelt. Der Teil 1 dieses Kontrollkanals beinhaltet Daten, welche der Empfänger unmittelbar decodieren muss, um ankommende Daten auf dem HS-DSCH HS-DSCH=HS-Downlink Shared Channel) entsprechend zu verarbeiten. Entsprechend ist das Vorliegen der Daten des Teil 2 (Part 2) weniger zeitkritisch.

Auf dem physikalischen Kanal, das heißt dem tatsächlichen Übertragungskanal, stehen aber für den Teil 1 des Kontrollkanals HS-SCCH nur 40 Bits für die Übertragung zur Verfügung. Um von 48 Bit auf die 40 Bits zu kommen, die in Teil 1 physikalisch übertragen können, erfolgt eine Ratenanpassung (Ratematching) nach folgendem Ratenanpassungsmuster (Pattern 1): Aus dem Bitblock oder der Sequenz Z₁, welche aus Codiervorgang C_LD hervorgeht, werden die Bits an den Positionen 1, 2, 4, 8, 42, 45, 47, 48 punktiert. Wird eine Schreibweise mit einem zweiten Index j verwendet, welcher die Bitposition kennzeichnet und im gezeigten Fall und 1 bis 48 läuft, dann lassen sich die zu punktierenden Bits angeben als Z_{1,1}, Z_{1,2,} Z_{1,4,} Z_{1,8,} Z_{1,42,} Z_{1,45,} Z_{1,47,} Z_{1,48}. Der erste Index gibt wie zuvor an, dass es sich um Teil 1 des HS-SCCH handelt. In dieser Schreibweise liegt dann in Figur 3 nach dem Ratenanpassungvorgang die Sequenz R_{1,1} R_{1,2,} ... R_{1,40} vor.

Der Kontrollkanal HS-SCCH wird von mehreren Mobilstationen oder Mobilfunkendgeräten (UE: User Equipment) abgehört. Zur Kennzeichnung der jeweils angesprochenen Mobilstation UE, beziehungsweise damit diese Mobilstation den Teil 1 decodieren kann und auch, damit eine Mobilstation, die nicht angesprochen ist, dies erkennt, werden die Nutzdaten, bestehend aus Kanalinformationsdaten und dem Modulationsschema durch die Identifikationsdaten beziehungsweise eine von der Identifizierungsnummer der Mobilstation abhängige spezifische Maske gekennzeichnet. Im hier abgebildeten Fall werden auf der 16 Bit umfassenden Identifizierungsnummer der Mobilstation (UE ID) mittels Rate ½-Codierung gemäß dem 1999 festgelegten Standard (Release 99) ein für die Identifizierungsnummer der Mobilstation spezifischer, sogenannter Scrambling-Code (Maske) generiert.

Die Identifizierungsnummer der Mobilstation UE ID wird der Mobilstation in der jeweiligen Zelle von der jeweiligen Basisstation zugewiesen.

Unter Scrambling versteht man eine "Personalisierung" der Information. Dies geschieht über sogenannte "Scrambling-Codes" mit denen das Signal modifiziert wird, um für einzelne Terminals oder Basisstationen bestimmte Signale voneinander zu separieren oder trennen.

Zur Generierung des Scrambling-Codes werden die 16 Bits der Identifizierungsnummer der Mobilstation UEID X_{ue,1}, ... X_{ue,16} und die angehängten acht Tail-Bits gemäß dem Standard von 1999 (Release 99) mit dem Rate ½-Faltungscodierer (C_ID) codiert. Damit ergeben sich am Ausgang des Faltungscodierers ebenfalls (16+8)x2=48 Bits einer Sequenz B. Um hier auf die Länge von 40 Bits zu kommen, wird für die Ratenanpassung RM_ID der Ratenanpassungsalgorithmus aus dem Standard 1999 (Release 99) zum Punktieren verwendet (RM_ID), bei dem von der Sequenz B bestehend aus den Bits b₁, b₂, ... b₄₈ ,wobei der Index die Bitposition angibt, werden die Bits b₁, b₇, b₁₃, b₁₉. b₂₅, b₃₁, b₃₇, b₄₃ punktiert. Mit der so gebildeten Sequenz C, bestehend aus den Bits c₁, c₂, ... c₄₀, ergibt sich die notwendige Reduktion von 48 Bits auf 40 Bits.

Es werden also für den Zweig der Nutzdaten LD und den Zweig der Identifikationsdaten ID für deren jeweilige Ratenanpassung RM_LD beziehungsweise RM_ID unterschiedliche Ratenanpassungsmuster verwendet. Dies hat folgende Gründe:
- im Allgemeinen liegen im Zweig mit den Identifikationsdaten ID beziehungsweise im Zweig mit den Nutzdaten LD nach der Codierungsstufe nicht die gleiche Anzahl von Bits vor. Dies kann sowohl an der Zahl der Ausgangsbits, das heißt der Anzahl von Bits der Identifizierungsnummer der Mobilstation beziehungsweise Kanalinformations- oder Modulationsinformationsbits liegen, als auch an der Rate der Codierung. Damit ist dann zwangsläufig eine unterschiedliche Ratenanpassung erforderlich.
- die Codierung in der Codierstufe C_{LD} bzw. C_{ID} dient unter anderem einer Verschränkung der Bits untereinander, so dass auf der Empfängerseite auch bei schlechten Übertragungsverhältnissen die ursprüngliche Bitfolge Xᵢ beziehungsweise X_{UE} wieder hergestellt werden kann. Eine in diesem Sinne gute Verschränkung sieht natürlich für unterschiedliche Eingangsdaten Xᵤₑ bzw. Xᵢ (=X_{ccs} oder Xₘₛ) unterschiedlich aus, insbesondere auch wenn unterschiedliche Codierungsraten verwendet werden. Demzufolge haben nach der Codierungsstufe einzelne Bits unterschiedliche Wichtigkeit. Diese unterschiedliche Wichtigkeit hängt davon ab, mit wie vielen Eingangsbits der Codierstufe ein Ausgangsbit der Codierstufe zusammenhängt. Je mehr Eingangsbits in das Ausgangsbit einfließen, desto wichtiger ist das Ausgangsbit um die ursprünglichen Daten wieder herzustellen. Bei einem Ratenanpassungsmuster werden im Falle einer Punktierung von Daten nun zumeist vorzugsweise solche Bits punktiert, welche eine in diesem Sinne weniger hohe Wichtigkeit aufweisen.
   In anderen Worten führen bei unterschiedlicher Codierung z.B. mit unterschiedlichen Faltungscodierern und anschließender Ratenanpassung unterschiedliche Ratenanpassungsmuster zu unterschiedlichen Distanzeigenschaften bezüglich der Hamming-Abstände der resultierenden Codefolgen beziehungsweise Codeworte und bestimmen damit die Leistungsfähigkeit der Codierung.

Die Verwendung von unterschiedlichen Ratenanpassungsmustern und der damit verbundenen Rechen- und Speicheraufwand stellen in der Basisstation nur ein geringes Problem dar, da dort die entsprechende Hardware zur Verfügung steht, auch Rechenprozesse mit hoher Komplexität zu bewältigen. Dies trifft jedoch nicht für die empfangende Mobilstation zu.

Ziel der Erfindung ist es wie gesagt, die Gesamtcodierung, insbesondere die Ratenanpassung weniger komplex zu gestalten, als es derzeit, das heißt der Spezifizierung gemäß dem Release 5 der Fall ist.

Ein Hauptaspekt der Erfindung ist dabei, die Ratenanpassung für Identifikationsdaten ID und Nutzdaten LD nach einem gemeinsamen Ratenanpassungsmuster vorzunehmen.
Dazu sind prinzipiell zwei Lösungswege denkbar:
i) Die Verwendung eines gemeinsamen Ratenanpassungsmusters, aber getrennte Durchführung der Ratenanpassung für Nutzdaten LD und Identifikationsdaten ID.
ii) Die Verwendung eines gemeinsamen Ratenanpassungsmusters und die gemeinsame Durchführung der Ratenanpassung.

### Figur 4

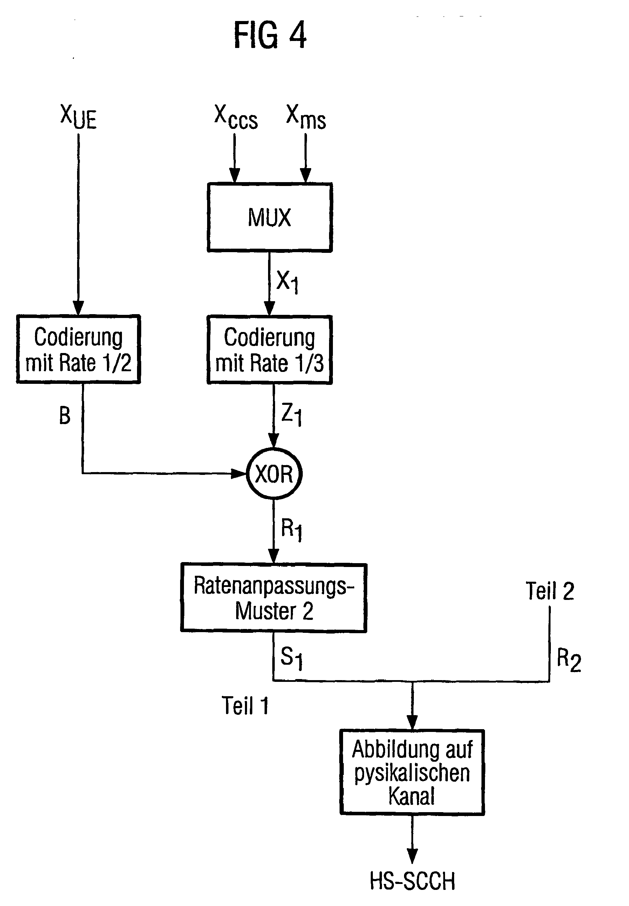

In Figur 4 ist nun ein nach Lösungsweg ii)ausgestalteter Verfahrensablauf, ebenfalls für das Beispiel des Kontrollkanals HS-SCCH, dargestellt. In diesem Fall werden die Identifikationsdaten ID, hier als Identifizierungsbitfolge Xᵤₑ bezeichnet, und die Kanalinformationsdaten hier X_{ccs} und Xₘₛ bereits nach der jeweiligen Codierung C_LD beziehungsweise C_ID miteinander verknüpft und dann einer gemeinsamen Ratenanpassung unterzogen. Die Verknüpfung geschieht beispielsweise durch eine XOR - Funktion, wenn man die zwei Werte, die ein Bit jeweils annehmen kann, mit 0 und 1 definiert. Falls die Werte - 1 und 1 angenommen werden, kann die Verknüpfung durch eine Multiplikation erfolgen. Auch andere bitweise Verknüpfungen lassen sich jedoch verwenden.

In Figur 4 werden, analog wie in Figur 3, die Daten, die aus dem Codiervorgang hervorgehen mit Z₁ bezeichnet.
In Abweichung von Figur 3 bezeichnet hier der Bitblock beziehungsweise die Bitfolge oder die Sequenz R₁ die Daten vor der gemeinsamen Ratenanpassung, jedoch nach der Verknüpfung.
Durch ein Vorgehen gemäß den Lösungswegen i) oder ii) werden folgende Vorteile erzielt:

Da die Ratenanpassung mit nur einem Ratenanpassungsmuster vorgenommen wird, gestaltet sich die Decodierung im Empfänger, beispielsweise der Mobilstation UE, entsprechend leichter. Eine geringere Komplexität wird bereits erreicht, wenn die Ratenanpassung für Identifikationsdaten ID und Nutzdaten LD separat nach dem selben Muster durchgeführt wird (Lösungsweg i).

Wird gemäß Lösungsweg ii) die Ratenanpassung zusammengefasst, bedeutet dies eine weitere Vereinfachung.

### Verschiedene Ratenanpassungsmuster

Ein weiterer Aspekt der Erfindung ist die Gestaltung eines Ratenanpassungsmusters, welches sich als gemeinsames Schema für Nutzdaten LD und Identifikationsdaten ID ungefähr gleichermaßen eignet. Ein wichtiger Gesichtspunkt ist hierbei unter anderem, dass der Hamming-Abstand nach der Verknüpfung möglichst groß ist, z.B. um die verknüpften Daten im Falle einer fehlerhaften Übertragung möglichst gut rekonstruieren zu können. Um weiterhin den Informationsgehalt der Nutzdaten möglichst gut zu erhalten, ist auch hier ein großer Hamming-Abstand wünschenswert. Diese und weitere Kriterien, wie beispielsweise das Signal/Rausch-Verhältnis sind jedoch nicht zwingend voneinander unabhängig, was unter anderem dazu führen kann, dass der Versuch, ein "optimiertes" Ratenanpassungsmuster zu finden, zu mehreren, unterschiedlichen Ratenanpassungsmustern führt, die in mathematischer Sprechweise eventuell auch als Nebenminima des Optimierungsproblems bezeichnet werden könnten.
Unter anderen weisen für das gemeinsame Ratenanpassungsmuster einige Varianten besondere Vorteile auf:
a) Verwendung des gegenwärtigen Punktierungs-Algorithmus verwendet (Release99):
   In der Sequenz r1,1, r1,2, ..., r1,48 werden die Bits r1,1, r1,7, r1,13, r1,19, r1,25, r1,31, r1,37, r1,43 punktiert, und man erhält so die Sequenz s1,1, s1,2...s1,40. Dies hat den Vorteil, dass nur geringe Anpassungen zum gegenwärtig verwendeten System erfolgen müssen.
   Dieses Punktierungsmuster kann- ebenso wie weitere Ratenanpassungsmuster- verschoben werden, beispielsweise durch eine Ablage (offset) 0 <= k < 6. Das heißt, dass für den Fall des Standards von 1999 (Release99), die Bits r₁₊ₖ, r₇₊ₖ, r₁₃₊ₖ, r₁₉₊ₖ, r₂₅₊ₖ, r₃₁₊ₖ, r₃₇₊ₖ, r₄₃₊ₖ punktiert werden.
b) Als Punktierungsmuster wird das für die Nutzdaten des Part 1 des HS-SCCH optimierte Punktierungsmsuter "Pattern 1" [1] verwendet:
   Von der Sequenz r1,1, r1,2, .., r1,48 werden die Bits r1,1, r1,2, r1,4, r1,8, r1,42, r1,45, r1,47, r1,48 punktiert, und man erhält so die Sequenz s1,1, s1,2...s1,40. Diese Variante ist besonders vorteilhaft, da sie die HS-SCCH Daten optimal codiert und ausserdem die Sequenzen zur Maskierung der Daten im Coderaum einen größeren Abstand untereinander haben, das heißt eine größere sogenannte "Hamming Distanz" als mit einer Punktierung gemäß dem Release99 Punktierungs-Algorithmus.
   Unter "Hamming-Distanz" wird die Anzahl von bits verstanden, durch die sich zwei gleich lange Codewörter voneinander unterscheiden. Dies wird zur Fehlererkennung eingesetzt, indem empfangene Dateneinheiten mit gültigen Zeichen verglichen werden. Eine eventuelle Korrektur erfolgt nach dem Wahrscheinlichkeitsprinzip.
c) Ein neues Punktierungspattern, welches gleichzeitig die Codierungseigenschaften der Daten des Part 1 des HS-SCCH und die Erkennungsmöglichkeiten der Maskierung mit der UE ID optimiert, kann durch eine Optimierung gelöst werden, wobei die Nebenbedingungen durch die Datenstruktur im Identifikations-Daten-Zweig und im Nutzdatenzweig vorgegeben sind.

### Vereinfachung der Decodierung auf Empfängerseite

Wie bereits dargelegt, stellt die vorgeschlagene Vereinfachung der Ratenanpassung insbesondere auf der Empfängerseite, also beispielsweise in einer Mobilstation, aufgrund der geringeren Komplexität der Decodierung einen großen Vorteil dar.
Unterschiede in der Decodierung, wie sie gegenwärtig erfolgt und wie sie gemäß der Erfindung erfolgen kann, werden im Folgenden dargelegt.

### Figur 5

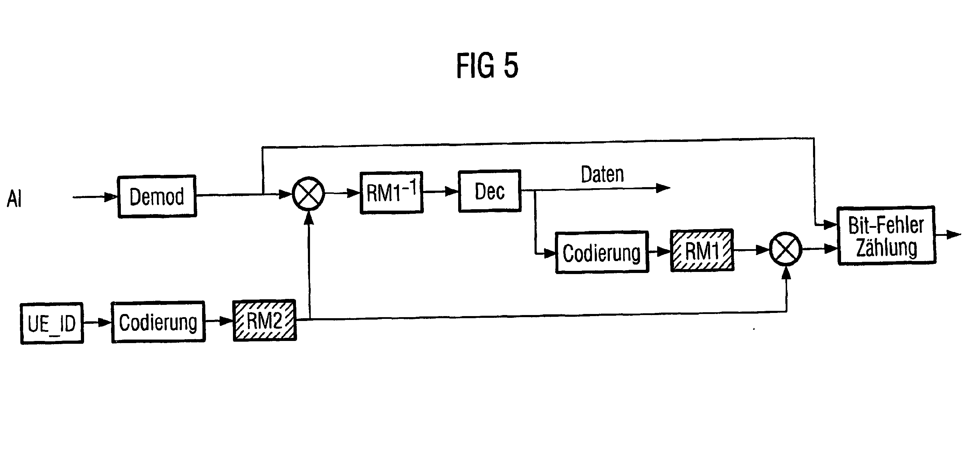

In Figur 5 ist eine beispielhafte Implementierung im Empfängergerät zu sehen, wie sie bei der gegenwärtigen Spezifizierung (Release 99) erforderlich ist. Über die Luftschnittstelle AI (Air Interface) werden die übertragenen Daten TD empfangen. Diese übertragenen Daten TD werden im Demodulator Demod demoduliert. Nach der Demodulation werden diese Daten einerseits direkt einer Bitfehlerzähleinheit (Bit Error Count) zugeführt. Andererseits werden diese Daten mit den Maskierungsdaten verknüpft, beispielsweise durch eine XOR-Verbindung oder eine Multiplikation. Die Maskierungsdaten werden in der Mobilstation aus der Identifizierungsnummer der Mobilstation UE ID, welche codiert wird und anschließend einer Ratenanpassung (RM2) unterzogen wird, generiert. Anschließend daran erfolgt die Verknüpfung mit den demodulierten, übertragenen Daten TD. Die Ratenanpassung RM2 der Maskierungsdaten ist erforderlich, um die Bitlängen der Maskierungsdaten an die Bitlänge der empfangenen Daten TD anzupassen.

Für das verknüpfte Signal erfolgt vor der Decodierung Dec eine Rückgängigmachung der Ratenanpassung RM1⁻¹. Diese Daten werden decodiert und zur Überprüfung, ob die Information für die jeweils empfangende Mobilstation bestimmt waren, erneut codiert und einer weiteren Ratenanpassung RM1 unterzogen, bevor sie erneut mit den Maskierungsdaten verknüpft werden. Das Ergebnis dieser neuerlichen Verknüpfung fließt ebenfalls in die Bitfehlerzähleinheit (Bit Error Count) ein. Die Detektion der Fehler basiert hier auf einer Bearbeitung von 40 Bits, also so vielen, Bits, wie über die Luftschnittstelle AI pro HS-SCCH Rahmen (HS-SCCH Subframe), der aus drei sogenannten Slots beziehungsweise Zeitschlitzen besteht, übertragen werden.

### Figur 6

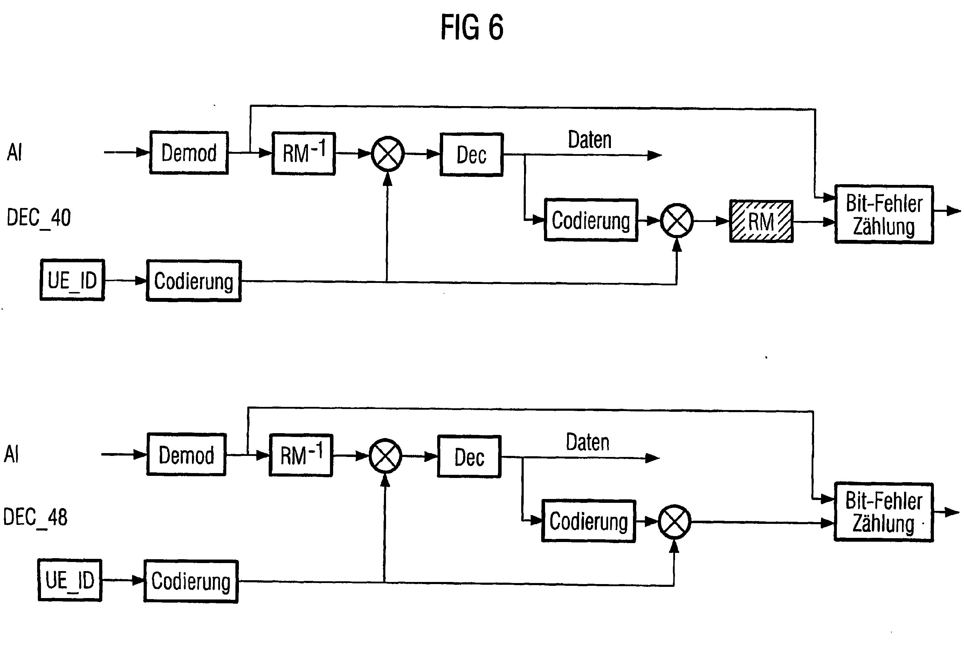

In Figur 6 sind zwei beispielhafte Implementierungen zu sehen, die mit einer erfindungsgemäß durchgeführten Ratenanpassung verwendet werden können.
Im oberen Bild (DEC_40) basiert die Bitfehlererkennung in der Bitfehlerzähleinheit Bit Error Count ebenfalls auf 40 Bits. Aufgrund des im Sender für Identifikationsdaten ID und Nutzdaten LD benutzten gleichen Ratenanpassungsmusters erfolgt die Ratenanpassung erst gemeinsam mit dem über die Luftschnittstelle empfangenen, übertragenen Daten TD, unmittelbar vor der Bitfehlerzähleinheit Bit Error Count.

Somit wird auf diese Weise gegenüber dem Stand der Technik eine Ratenanpassung eingespart, nämlich die - wie aus Figur 5 ersichtlich - der Maskierungsdaten vor einer Verknüpfung mit den empfangenen Daten.

Im einzelnen sind in Figur 6 im oberen Beispiel folgende Schritte gezeigt:
Die übertragenen Daten TD werden über die Luftschnittstelle AI empfangen. Nach einem Demodulationsvorgang Demod werden die Daten aufgeteilt und fließen einerseits in einem ersten Zweig direkt in eine Bitfehlerzähleinheit Bit Error Count ein, im anderen Zweig erfolgt eine Rückgängigmachung oder Annullierung der Ratenanpassung RM⁻¹ und eine anschließende Verknüpfung mit den Maskierungsdaten, welche durch eine Codierung Coding der Mobilstationsidentifikationsnummer generiert werden. Im Gegensatz zu der in Figur 5 gezeigten Implementierung ist keine Ratenanpassung der Maskierungsdaten erforderlich, da die Ratenanpassung der übertragenen Daten bereits vor der Verknüpfung rückgängig gemacht wurde.
Die verknüpften Daten erfahren eine Decodierung in einem Decodierungsvorgang Dec. Einerseits liegen dann die benötigten Daten Data vor, andererseits werden diese Daten in einem weiteren Codierungvorgang Coding unterzogen und erneut mit den Maskierungsdaten verknüpft. Dies geschieht zum Zwecke der Fehlererkennung in der Bitfehlerzähleinheit Bit Error Count, in welche diese Daten nach der erneuten Verknüpfung sowie einem Ratenanpassungvorgang RM fließen.
Zusammenfassend wird also im Vergleich zu der in Figur 5 gezeigten Implementierung eine Ratenanpassung eingespart.
Dies wird durch die Verwendung eines gemeinsamen Ratenanpassungsmusters für Nutzdaten LD und Maskierungdaten ID im Sender ermöglicht; bei der Verwendung unterschiedlicher Ratenanpassungsmuster würde die gemeinsame Ratenanpassung in der Ratenanpassungseinheit RM in Figur 6 vor der Bitfehlerzähleinheit z.B. nicht auf das ursprüngliche Signal führen.
Noch deutlichere Verbesserungen, nämlich die Einsparung von zwei Ratenanpassungen, werden in der im unteren Bild von Figur 6 gezeigten Implementierung erzielt.
Im unteren Bild (DEC_48) basiert die Detektion der Bitfehler auf 48 Bits. In diesem Fall ist lediglich die Rückgängigmachung der Ratenanpassung durchzuführen. Eine weitere Ratenanpassung wird nicht mehr benötigt.

Im einzelnen werden in der unteren Darstellung in Figur 6 folgende Schritte durchgeführt: Die übertragenen Daten TD werden über die Luftschnittstelle AI empfangen. Anschließend erfolgt eine Annullierung der Ratenanpassung RM⁻¹, welche erforderlich ist, da die Daten einerseits in einem ersten Zweig direkt zur Bitfehlerzähleinheit Bit Error Count geleitet werden, in welcher die Bitfehlererkennung auf Basis von 48 Bits stattfindet.
Andererseits erfolgt in einem zweiten Zweig eine Verknüpfung dieser Daten mit den in der Mobilstation aus der Mobilstationsidentifikationsnummer UE ID generierten Maskierungsdaten.
Nach der Verknüpfung und einer anschließendenden Decodierung Dec liegen dann die benötigten Daten vor. Analog wie im oberen Beispiel werden die Daten zur nachfolgenden Fehlererkennung wieder einer Codierung Cod unterzogen und dann mit den Maskierungsdaten verknüpft. Eine Ratenanpassung nach der Verknüpfung ist im Gegensatz zum oberen Beispiel in Figur 6 nicht erforderlich, da 48 Bits vorliegen, auf deren Basis auch die Fehlererkennung geschieht.
Somit ist in dieser Implementierung keine Ratenanpassung erforderlich.

### Weitere Anwendungsmöglichkeiten

Die gemeinsame Verwendung von Ratenanpassungsmustern wurde insbesondere für den HS-SCCH erläutert, ist jedoch nicht auf diesen beschränkt. Auch bei anderen Kontrollkanälen wird eine Maskierung der Nutzdaten verwendet, wodurch die Erfindung nutzbar ist. Weitere Anwendungen ergeben sich im Prinzip für alle Kanäle, in denen verschiedenen Datenströme zur Übertragung miteinander verknüpft werden und eine Ratenanpassung erforderlich ist.

### Abkürzungen

- HSDPA: High Speed Downlink Packet Access
- HS-DSCH: High Speed Downlink Shared Channel (Daten)
- HS-SCCH: High Speed Shared Control Channel (Kontrollinformation, Signalisierung)
- UE: User Equipment (Bezeichnung für eine UMTS-Mobilstation)
- ID: Identifikations-Nummer

### Quellen:

[1] R1-02-0605, "Coding and Rate Matching for HS-SCCH", TSG RAN WG1 Meeting #25, Paris, 09-12.04.2002.

## Patentansprüche

1. Verfahren zur Übertragung von Daten mit einer festgelegten Anzahl von Bits über einen von zumindest einer ersten Sende- und Empfangseinheit und einer zweiten Sende-und Empfangseinheit genutzten physikalischen Kanal in einem Kommunikationssystem ,
- bei dem sich die zu übertragenden Daten (TD) aus Nutzdaten (LD) und Identifikationsdaten (ID) zur Kennzeichnung des zweiten Kommunikationsgeräts zusammensetzen,
- bei dem die Nutzdaten (LD) und die Identifikationsdaten (ID) getrennt voneinander mittels je einer Faltungskodierung kodiert werden,
- und die Faltungskodierung (C_LD, C-ID) jeweils derart erfolgt, dass sich für Nutzdaten (LD) und Identifikationsdaten (ID) die gleiche Anzahl von Bits nach dem Kodiervorgang ergibt,
- bei dem die codierten Nutzdaten (LD) und die codierten Identifikationsdaten (ID) durch eine XOR-Verknüpfung miteinander verknüpft werden, **dadurch gekennzeichnet, dass**
- eine Ratenanpassung der miteinander verknüpften Daten an die für den physikalischen Kanal festgelegte Anzahl von Bits unter Verwendung eines Ratenanpassungsmusters unmittelbar vor oder unmittelbar nach der XOR Verknüpfung erfolgt, wobei das Ratenanpassungsmuster festlegt, welche Bits aus einem Datenstrom punktiert oder repetiert werden,
- wobei das Ratenanpassungsmuster für Nutzdaten (LD) und Identifizierungsdaten (ID) dasselbe ist.

2. Verfahren nach Anspruch 1, bei dem der Kodierungsvorgang eine Bitsequenz von Bits 1 bis n in einem festgelegten Zeitfenster liefert, wodurch die Rate festgelegt ist,
- und die Ratenanpassung durch ein Ratenanpassungsmuster vorgenommen wird, durch das einzelne Bits aus dieser Sequenz punktiert werden.

3. Verfahren nach einem der vorhergehenden Ansprüche, bei dem es sich bei dem physikalischen Kanal um den High Speed Shared Control Channel (HS-SCCH) handelt.

4. Verfahren nach einem der vorhergehenden Ansprüche, bei denen es sich bei den Identifikationsdaten um die Identifikationsnummer einer Sende/Empfangseinheit handelt.

5. Verfahren nach Anspruch 3 und 4, bei dem die Ratenanpassung mit einem Ratenanpassungsmuster erfolgt, durch das in der aus n= 48 Bits bestehenden Bitsequenz die Bits an den Positionen 1, 2, 4, 8, 42, 45, 47, 48 punktiert werden.

6. Verfahren nach Anspruch 3 und 4, bei dem in der aus n= 48 Bits bestehenden Bitsequenz die Bits an den Positionen 1, 7, 13, 19, 25, 31, 37, 43 punktiert werden.

7. Verfahren nach Anspruch 6, bei dem die Position der zu punktierenden Bits um eine ganze Zahl k verschoben wird, wobei 0<k<=5 gilt.

8. Verfahren nach einem der vorhergehenden Ansprüche, bei dem es sich bei der Verknüpfung um eine bitweise Verknüpfung handelt.

## Claims

1. A method for transmitting data with a defined number of bits via a physical channel in a communication system, said channel being used by at least one first transceiver and one second transceiver,
- wherein the data to be transmitted (TD) is composed of load data (LD) and identification data (ID) for identifying the second communication device,
- wherein the load data (LD) and the identification data (ID) are coded separately from each other using convolutional coding in each case,
- and the respective convolutional coding (C_LD, C_ID) takes place in such a way that the same number of bits is produced after the coding operation for the load data LD and the identification data ID,
- wherein the coded load data (LD) and the coded identification data (ID) are linked with each other by means of an XOR linking operation, **characterised in that**
- the rate of the linked data is matched to the number of bits defined for the physical channel using a rate matching pattern immediately before or immediately after the XOR linking operation, with the rate matching pattern defining which bits in a data stream are punctured or repeated,
- wherein the rate matching pattern for the load data (LD) and the identification data (ID) is identical.

2. The method according to claim 1, wherein the coding operation supplies a bit sequence of bits 1 to n in a defined time window by means of which the rate is defined,
- and rate matching is performed by means of a rate matching pattern by which individual bits in said sequence are punctured.

3. The method according to one of the preceding claims, wherein the physical channel is the High Speed Shared Control Channel (HS-SCCH).

4. The method according to one of the preceding claims, wherein the identification data is the identification number of a transceiver.

5. The method according to claim 3 and 4, wherein the rate matching takes place using a rate matching pattern by which the bits at positions 1, 2, 4, 8, 42, 45, 47, 48 are punctured in the bit sequence consisting of n = 48 bits.

6. The method according to claim 3 and 4, wherein the bits at positions 1, 7, 13, 19, 25, 31, 37, 43 are punctured in the bit sequence consisting of n = 48 bits.

7. The method according to claim 6, wherein the position of the bits being punctured is shifted by a whole number k, where 0<k<=5.

8. The method according to one of the preceding claims, wherein linking is bit-by-bit linking.

## Revendications

1. Procédé de transmission de données avec un nombre déterminé de bits sur un canal physique utilisé par au moins une première unité émettrice et réceptrice et une deuxième unité émettrice et réceptrice dans un système de communication, dans lequel
- les données à transmettre (TD) se composent de données utiles (LD) et de données d'identification (ID) pour caractériser le deuxième appareil de communication,
- les données utiles (LD) et les données d'identification (ID) sont codées séparément les unes des autres au moyen de respectivement un codage convolutif et
- le codage convolutif (C_LD, C_ID) est opéré respectivement de manière telle que, après l'opération de codage, on obtient le même nombre de bits pour les données utiles (LD) et les données d'identification (ID),
- les données utiles (LD) codées et les données d'identification (ID) codées sont combinées entre elles par une combinaison XOR, **caractérisé en ce que**
- une adaptation de débit des données combinées entre elles au nombre de bits déterminé pour le canal physique se fait moyennant l'utilisation d'un modèle d'adaptation de débit directement avant ou directement après la combinaison XOR, le modèle d'adaptation de débit établissant quels bits sont poinçonnés hors du flux de données ou sont répétés,
- le modèle d'adaptation de débit étant le même pour les données utiles (LD) et les données d'identification (ID).

2. Procédé selon la revendication 1, dans lequel l'opération de codage fournit une séquence de bits 1 à n dans une fenêtre de temps déterminée, ceci déterminant le débit,
- et l'adaptation de débit étant opérée par un modèle d'adaptation de débit par lequel des bits individuels sont poinçonnés hors de cette séquence.

3. Procédé selon l'une des revendications précédentes, dans lequel pour le canal physique il s'agit du High Speed Shared Control Channel (HS-SCCH).

4. Procédé selon l'une des revendications précédentes, dans lequel pour les données d'identification il s'agit du numéro d'identification d'une unité émettrice / réceptrice.

5. Procédé selon la revendication 3 et 4, dans lequel l'adaptation de débit se fait avec un modèle d'adaptation de débit par lequel les bits sont poinçonnés aux positions 1, 2, 4, 8, 42, 45, 47, 48 dans la séquence de bits composée de n = 48 bits.

6. Procédé selon la revendication 3 et 4, dans lequel les bits sont poinçonnés aux positions 1, 7, 13, 19, 25, 31, 37, 43 dans la séquence de bits composées de n = 48 bits.

7. Procédé selon la revendication 6, dans lequel la position des bits à poinçonner est décalée d'un nombre entier k avec 0 < k <= 5.

8. Procédé selon l'une des revendications précédentes, dans lequel la combinaison est une combinaison bit par bit.
